Europäisches Patentamt

European Patent Office

Office européen des brevets

(19)

(11) Numéro de publication: **0 200 597**
**B1**

(12) **FASCICULE DE BREVET EUROPEEN**

(45) Date de publication du fascicule du brevet:
25.04.90

(21) Numéro de dépôt: 86400662.2

(22) Date de dépôt: 27.03.86

(51) Int. Cl.⁴: **H05K 7/14**

(54) Dispositif antivibratoire pour cartes électroniques.

(30) Priorité: 29.03.85 FR 8504849

(43) Date de publication de la demande:
10.12.86 Bulletin 86/45

(45) Mention de la délivrance du brevet:
25.04.90 Bulletin 90/17

(84) Etats contractants désignés:
DE GB IT NL

(56) Documents cités:
EP-A- 0 014 391
DE-A- 3 310 109

(73) Titulaire: THOMSON-CSF, 51, Esplanade du Général de
Gaulle, F-92800 Puteaux(FR)

(72) Inventeur: Lamy, Michel, THOMSON-CSF
SCPI 19, avenue de Messine, F-75008 Paris(FR)

(74) Mandataire: Benoit, Monique et al, THOMSON-CSF
SCPI, F-92045 PARIS LA DEFENSE CEDEX 67(FR)

## Description

La présente invention concerne les dispositifs pour cartes électroniques permettant d'immobiliser les cartes lorsqu'elles sont placées dans leur bac récepteur.

Les cartes électroniques sont disposées dans un bac récepteur auquel elles sont connectées électriquement. Le maintien des cartes à l'intérieur du bac est réalisé d'une part par les connecteurs et d'autre part par l'emploi de glissières. Les cartes sont insérées entre les glissières. Pour de nombreuses applications lorsqu'on emploie des cartes de format standard, les glissières et les connecteurs suffisent à maintenir la carte dans le bac.

De plus en plus on est amené à utiliser des cartes au format triple Europe qui est plus grand que le format standard. Ces cartes sont plus sensibles aux sollicitations dues à l'environnement ainsi qu'aux contraintes exercées lors de l'insertion ou de l'extraction. On utilise des raidisseurs du type cornière pour renforcer la structure de la carte et empêcher les déformations de celle-ci et des ruptures au niveau des connexions des composants.

Dans certaines applications les bacs sont placés dans un environnement peu favorable et subissent des vibrations qui sont transmises aux cartes, ces vibrations pouvant être amplifiées par des phénomènes de résonance des cartes ou des composants. Selon que les fréquences de résonance sont basses ou élevées ce sont soit les connexions, soit les composants qui peuvent être altérés.

Le brevet EP-A 0 014 391 utilise le principe de l'immobilisation de cartes électroniques, disposées dans un bac récepteur, par des entretoises placées sur chacune des cartes.

Pour remédier à ces inconvénients la présente invention propose un dispositif antivibratoire tel que défini dans la revendication 1.

L'invention sera mieux comprise à l'aide de la description suivante présentée à titre d'exemple non limitatif et faite en regard des figures du dessin annexé sur lequel:

la figure 1 représente le schéma général du dispositif selon l'invention;
la figure 2 représente une vue en perspective du support et des moyens selon la figure 1;
la figure 3 représente une coupe AB suivant un plan vertical selon la figure 1;
la figure 4 représente une coupe CD suivant un plan horizontal selon la figure 1.

On définit conventionnellement le plan vertical comme étant un plan parallèle aux parois avant et arrière du bac récepteur, et le plan horizontal, un plan perpendiculaire.

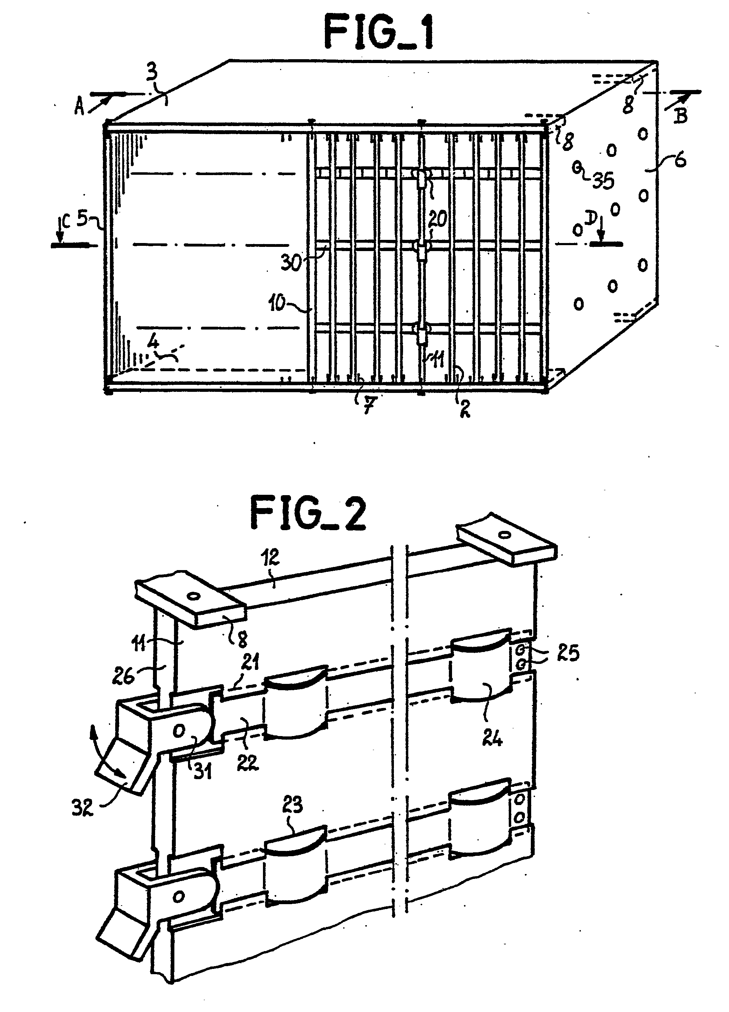

Sur la figure 1 on a représenté en perspective un bac récepteur dans lequel sont disposées des cartes électroniques 2. Le bac récepteur est constitué par une cavité généralement parallélépidémique délimitée par un ensemble de plaques parallèles deux à deux, les plaques que conventionnellement on qualifiera de dessus 3 et de dessous 4 comportent des glissières 7 en vis-à-vis entre lesquelles sont insérées les cartes 2. Les cartes électroniques sont ainsi disposées parallèlement les unes aux autres et aux parois latérales 5 et 6 du bac à l'intérieur du bac. La structure rigide du bac est renforcée par la présence de traverses 8 qui sont placées au-dessus et au-dessous des cartes électroniques et qui sont solidaires des plaques du dessus et du dessous.

Selon le mode de réalisation particulier choisi le bac a été divisé en deux parties à l'aide d'une plaque 10 rigide et solidaire des plaques du dessus 3 et du dessous 4 du bac, cette plaque 10 étant disposée parallèlement aux cartes électroniques et prenant l'emplacement d'une de ces cartes par exemple.

Le dispositif selon l'invention est placé dans chacune des deux parties du bac ainsi constituées. Bien entendu pour un bac plus petit cette division ne serait pas nécessaire et pour un bac beaucoup plus grand on procéderait à autant de divisions qu'il serait jugé nécessaire afin d'obtenir les meilleurs résultats.

Pour simplifier la description on ne décrira que la partie droite de la figure qui a été représentée, il est bien évident que la partie gauche présente exactement les mêmes structures. Dans toute la description, les mêmes éléments portent les mêmes références.

Le lot de cartes ainsi défini dans cette partie droite de la figure 1 est séparé en deux par une plaque rigide 11 solidaire du dessus 3 et du dessous 4 du bac. Chaque lot de cartes est inséré entre cette plaque rigide 11 et l'une des parois latérales du bac. La plaque 11 constitue le support à des moyens mécaniques 20 qui permettent d'exercer des efforts transversaux et ponctuels sur les cartes qui se situent de chaque côté de la plaque. Les efforts sont exercés sur plusieurs niveaux de part et d'autre de la carte support 11 et pour un niveau donné, les efforts sont répartis en différents points de manière à constituer un quadrillage des cartes. Les cartes électroniques sont équipées de moyens mécaniques 30 qui permettent de transmettre ces efforts aux cartes adjacentes. Les plaques latérales du bac sont équipées de moyens 35 qui permettent de s'opposer à cet effort.

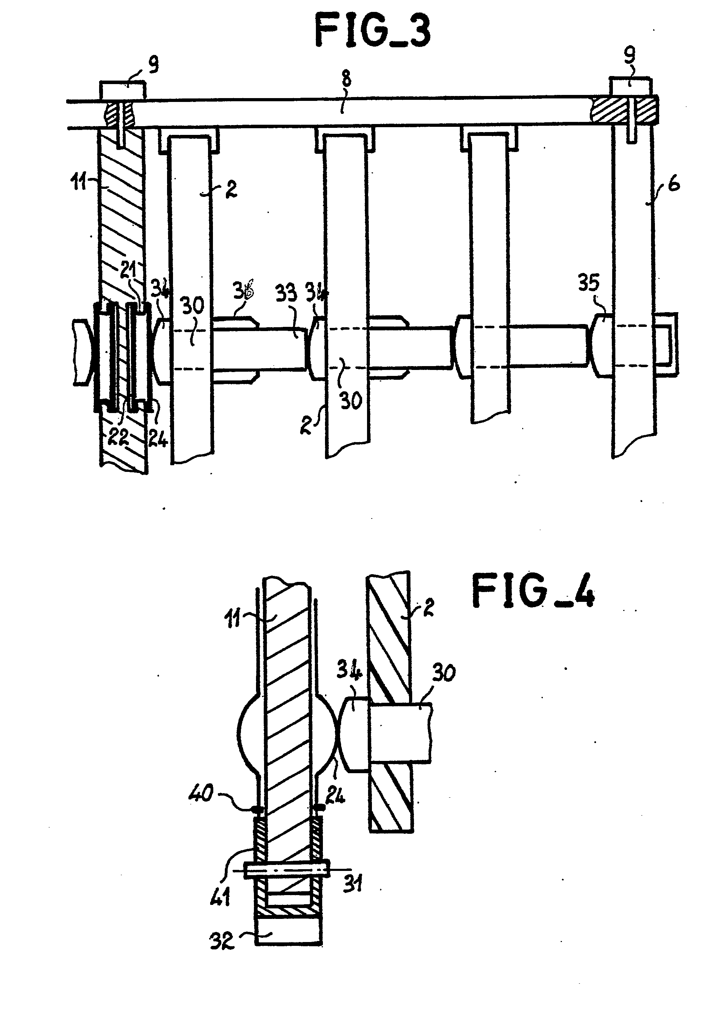

La figure 2 représente une vue détaillée et partielle des moyens d'action 20 et de leur support 11.

Le support 11 est solidaire des traverses 8 de vis de fixation 9 par exemple. Ce support 11 qui est constitué d'une plaque métallique rigide comporte sur chacune de ces faces un ensemble de glissières 21 dans lesquelles est insérée une lame de ressort 22. Les glissières se situent deux à deux à des mêmes niveaux de part et d'autre de la plaque 11.

On a représenté deux glissières chacune à un niveau différent de l'autre, les glissières de même niveau étant situées de l'autre côté de la plaque qui n'est pas visible. Les glissières 21 sont disposées dans un plan parallèle aux factes latérales de la plaque 11 et dans cet exemple particulier, selon des axes parallèles aux bords supérieur 12 et inférieur de la plaque. Chaque glissière présente des interruptions 23 réparties sur toute sa longueur, les lames ressort 22 comportent des voûtes 24 également réparties sur toute la longueur.

Lorsque la lame est insérée dans la glissière les interruptions de la glissière 21 permettent de laisser émerger les voûtes 24 de la lame. La lame ressort 22 est fixée à la plaque par son extrémité située vers le fond du bac, les moyens de fixation étant des moyens de fixation étant des moyens classiques du type vis 25. Sur le bord avant 26 de la plaque 11, le bord avant étant le bord accessible du bac, sont placés des dispositifs de leviers cames au niveau de chaque glissière.

Le dispositif levier-came est constitué par une came 31 dont l'axe est décentré et par un levier 32 qui permet d'actionner la came. Lorsque le levier est levé suivant le sens de la flèche, la came 31 n'exerce aucun effort sur la came ressort et celle-ci est à l'état de repos. Lorsque le levier est baissé la came exerce une poussée à l'extrémité libre de la lame ressort, suffisante pour provoquer un gonflement des voûtes qui comme cela sera décrit ultérieurement provoque des efforts transversaux au niveau des cartes électroniques, les efforts transversaux étant des efforts perpendiculaires à ces cartes.

Sur la figure 3 on a représenté une vue partielle du dispositif selon l'invention suivant une coupe AB. La coupe AB est réalisée selon le plan vertical. Cette figure permet de mettre en évidence les moyens de transmission qui propagent l'effort exercé au niveau de chaque voûte des lames ressort sur chaque carte et les moyens de réaction qui permettent de s'opposer à ces efforts de manière à immobiliser ponctuellement chaque carte.

Chaque carte est équipée d'entretoise qui sont réalisées plus particulièrement à l'aide de vis serrées par des écrous 36, la tête de vis de la première carte placée immédiatement après la carte 11 est appliquée contre la voûte de la lame ressort 24. L'extrémité 33 de la vis 30 est appliquée contre la tête 34 de la vis 30 placée sur la carte qui vient juste après la première carte. Cette même disposition est réalisée pour toutes les autres cartes. L'extrémité de la vis de la dernière carte vient s'appuyer sur une tête de vis 35 solidaire de la paroi latérale 6 du bac, cette paroi étant rigide.

Lorsque la voûte de la lame 22 est soulevée elle applique un effort sur la tête de vis de la première carte cet effort étant transmis successivement aux autres cartes, la tête de vis 35 qui est solidaire de la plaque latérale du bac vient s'opposer à cet effort de manière à ce que les cartes soient calées les unes par rapport aux autres et donc immobiles.

Sur la figure 4 on a représenté une vue partielle selon la coupe CD faite selon un plan horizontal. Cette coupe permet de mettre en évidence l'action du levier came sur la lame ressort 22. Lorsque le levier 32 est baissée les deux flancs 41 de la came viennent pousser une butée 40 qui pousse les lames ressort de chaque côté de la carte 11. Les parties de la lame voûtée se gonflent comme cela a déjà été décrit sous l'effet poussée et exercent donc un effort perpendiculaire aux cartes au niveau des têtes de vis ces têtes ayant été choisies préférentiellement d'une forme hémisphérique ce qui permet d'avoir un meilleur contact entre la voûte et la tête de vis ceci afin de concentrer l'effort exercé.

Les cartes électroniques sont par conséquent équipées d'entretoises qui selon notre exemple particulier sont réalisées à l'aide de vis serrées par des écrous, ces entretoises sont disposées de manière à former un quadrillage sur la carte. Ce quadrillage constitue l'emplacement des points d'immobilisation de la carte, l'emplacement de ces points dépend bien entendu des conditions dans lesquelles seront soumises les cartes.

Pour des raisons de clarté et de simplification, on a représenté les voûtes 24 selon un certain alignement de sorte que l'implantation des entretoises 35 se situe suivant un quadrillage régulier qui donne un alignement selon les bords 12 et les bords 26. Il est évident que pour des raisons d'implantation des composants sur les cartes, on peut placer les voûtes 24 de sorte que les entretoises 25 soient alignées uniquement selon le bord 12 ou uniquement selon le bord 26.

## Revendications

1. Dispositif antivibratoire pour cartes électroniques disposées dans un bac récepteur, le dispositif comportant des entretoises (30), placées sur chaque carte, immobilisant les cartes les unes par rapport aux autres par rapport à des moyens mécaniques d'appui (35) solidaires d'une paroi (6) du bac, dispositif caractérisé en ce qu'un support (11) placé entre deux lots de cartes comporte des moyens d'action (22, 24) permettant d'exercer des efforts transversaux sur les entretoises (30).

2. Dispositif selon la revendication 1, caractérisé en ce que le support (11) est constitué par une plaque rigide et solidaire du bac.

3. Dispositif selon la revendication 1, caractérisé en ce que les moyens d'action (20) comportent un levier (32) susceptible d'actionner au moins une came (31) l'ensemble étant solidaire du support (11), une lame ressort (22) logée en partie dans une glissière (21) du support (11) et comportant au moins une voûte (24), émergeant de la glissière (21) la lame étant fixée par l'une de ses extrémités au support, l'autre extrémité étant susceptible d'être comprimée par la came (31).

4. Dispositif selon la revendication 1 ou 2, caractérisé en ce que les entretoises sont alignées suivant des axes selon lesquels sont exercés les efforts transversaux.

5. Dispositif selon l'une des revendications précédentes, caractérisé en ce que les entretoises sont constituées par des vis (30) traversant les cartes sur lesquelles elles sont placées et serrées par des écrous (36).

6. Dispositif selon la revendication 5, caractérisé en ce que les têtes (34) des vis (30) sont hémisphériques.

## Claims

1. An antivibration device for use with electronic cards disposed in a receiver box, the device comprising spacers (30), placed on each card and adapted to immobilize the cards relative to one another and to mechanical abutment means (35) fixed to a wall (6) of the box, characterized in that a support (11) placed between two sets of cards comprises action means (22, 24) permitting to apply transversal forces to the spacers (30).

2. A device according to claim 1, characterized in that the support (11) is constituted by a rigid panel fixed to the box.

3. A device according to claim 1, characterized in that the action means (20) comprise a lever (32) susceptible of actuating at least one cam (31), these components being fixed to the support (11), and a blade spring (22) partially located in a slideway (21) of the support (11) and comprising at least one arch (24) emerging from the slideway (21), the blade being fixed with one of its ends to the support, whereas the other end is adapted to be compressed by the cam (31).

4. A device according to claim 1 or 2, characterized in that the cross members are aligned along axes along which the transversal forces are applied.

5. A device according to one of the preceding claims, characterized in that the spacers are constituted of screws (30), which traverse the cards onto which they are placed and fastened by means of nuts (36).

6. A device according to claim 5, characterized in that the heads (34) of the screws are shaped hemispherically.

**Patentansprüche**

1. Vibrationsschutzvorrichtung für in einem Aufnahmegehäuse angeordnete Elektronikkarten, wobei die Vorrichtung Abstandshalter (30) aufweist, die auf jeder Karte angebracht sind und die Karten untereinander und in Bezug auf mechanische Abstützmittel (35) festlegen, die mit einer Wand (6) des Gehäuses verbunden sind, dadurch gekennzeichnet, daß eine zwischen zwei Kartensätzen angeordnete Stütze (11) Betätigungsmittel (22, 24) aufweist, die es gestatten, auf die Abstandshalter (30) Querkräfte auszuüben.

2. Vorrichtung nach Anspruch 1, dadurch gekennzeichnet, daß die Stütze (11) aus einer steifen Platte besteht und mit dem Gehäuse fest verbunden ist.

3. Vorrichtung nach Anspruch 1, dadurch gekennzeichnet, daß die Betätigungsmittel (20) einen Hebel (32) zur Betätigung mindestens eines Nockens (31), wobei das ganze fest mit der Stütze (11) verbunden ist, und eine Blattfeder (22) aufweist, die teilweise in einer Gleitführung (21) der Stütze (11) untergebracht ist und mindestens eine Wölbung (24) besitzt, die aus der Gleitführung (21) hervortritt, wobei die Feder mit einem ihrer Enden an der Stütze befestigt ist, während das andere Ende durch den Nocken (31) komprimiert werden kann.

4. Vorrichtung nach Anspruch 1 oder 2, dadurch gekennzeichnet, daß die Abstandshalter entlang Achsen fluchtend angeordnet sind, entlang denen die Querkräfte ausgeübt werden.

5. Vorrichtung nach einem der vorhergehenden Ansprüche, dadurch gekennzeichnet, daß die Abstandshalter aus Schrauben (30) bestehen, die die Karten durchdringen, an denen sie angebracht sind, und mit Muttern (36) festgespannt sind.

6. Vorrichtung nach Anspruch 5, dadurch gekennzeichnet, daß die Köpfe (34) der Schrauben (30) halbkugelförmig sind.

EP 0 200 597 B1

# FIG_1

# FIG_2

# FIG_3

# FIG_4